(19) Europäisches Patentamt / European Patent Office / Office européen des brevets

(11) **EP 4 390 462 A1**

(12) **EUROPEAN PATENT APPLICATION**

(43) Date of publication:
   **26.06.2024 Bulletin 2024/26**

(21) Application number: **23217251.0**

(22) Date of filing: **15.12.2023**

(51) International Patent Classification (IPC):
   ***G01T 1/17*** (2006.01)    ***G01T 1/29*** (2006.01)
   ***H01J 37/28*** (2006.01)

(52) Cooperative Patent Classification (CPC):
   **G01T 1/171; G01T 1/2992; H01J 37/244;**
   H01J 2237/2446; H01J 2237/24495; H01J 2237/26

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **KH MA MD TN**

(30) Priority: **21.12.2022 US 202263476535 P
   07.06.2023 US 202318330743**

(71) Applicant: **FEI Company
   Hillsboro, OR 97124-5793 (US)**

(72) Inventors:
   • **MULDER, Jaap
     Hillsboro (US)**
   • **JANSSEN, Bart
     Hillsboro (US)**
   • **VAN DER HEIDE, Auke
     Hillsboro (US)**

(74) Representative: **Boult Wade Tennant LLP
   Salisbury Square House
   8 Salisbury Square
   London EC4Y 8AP (GB)**

(54) **DETECTING CHARGED PARTICLE EVENTS AT HIGH DOSE RATES**

(57)    Charged particle microscope (CPM) support systems and apparatus, as well as related methods, computing devices, and computer-readable media. One charged particle microscope support apparatus includes first logic to detect a first charged particle event at a first pixel of a charged particle camera, and second logic to detect, within a subregion of pixels of the charged particle camera containing the first pixel, whether a second charged particle event is present based on a dose rate and an energy value of each pixel within the subregion of pixels. When the second charged particle event is determined to be present, the second logic determines a location of the second charged particle event within the subregion. The support apparatus further includes third logic to output charged particle event data representing the first charged particle event and the second charged particle event.

EP 4 390 462 A1

**Description**

Related Applications

This application claims the benefit of U.S. Provisional Patent Application No. 63/476,535, filed December 21, 2022, the entire content of which is hereby incorporated by reference herein.

Field

Embodiments described herein relate generally to charged particle microscopy, and more particularly to detecting charged particle events.

Summary

Microscopy is the technical field of using microscopes to better view objects that are difficult to see with the naked eye. Different branches of microscopy include, for example, optical microscopy, charged particle (e.g., electron and/or ion) microscopy, and scanning probe microscopy. Charged particle microscopy involves using a beam of accelerated charged particles as a source of illumination. Types of charged particle microscopy include, for example, transmission electron microscopy, scanning electron microscopy, scanning transmission electron microscopy, and ion beam microscopy.

Further aspects of the present disclosure as set forth in the following numbered clauses:-

Clause 1. A charged particle microscope, comprising:
a support apparatus, including logic to:

detect a first charged particle event at a first pixel of a charged particle camera;
determine, within a subregion of pixels of the charged particle camera containing the first pixel, whether a second charged particle event is present based on a dose rate and an energy value of each pixel within the subregion of pixels;
when the second charged particle event is determined, determine a location of the second charged particle event within the subregion of pixels; and
output charged particle event data representing the first charged particle event and the second charged particle event.

Clause 2. The charged particle microscope of clause 1, wherein the support apparatus determines the location of the second charged particle event based on a second pixel within the subregion of pixels having a sub-maximum energy value, the sub-maximum energy value being a maximum of energy values within the subregion of pixels excluding the energy value of the first pixel.

Clause 3. The charged particle microscope of clause 1, wherein the support apparatus determines whether the second charged particle event is present by:

determining, for each pixel within the subregion of pixels, a probability of a charged particle impinging the pixel, and
determining that the second charged particle event is present based on the probability determined for each pixel within the subregion of pixels.

Clause 4. The charged particle microscope of clause 1, wherein the support apparatus determines whether the second charged particle event is present by:

determining, for each pixel within the subregion of pixels, a probability of a charged particle impinging the pixel,
determining a probability total by adding a minimum probability within the subregion of pixels and a maximum probability within the subregion of pixels, and
determining that the second charged particle event is present in response to the probability total being greater than a predetermined threshold.

Clause 5. The charged particle microscope of clause 4, wherein the predetermined threshold is set based on the dose rate.

Clause 6. The charged particle microscope of clause 1, wherein the subregion of pixels includes a square area of 3 to 5 pixels.

Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.

FIG. 1 is a block diagram of an example charged particle microscope (CPM) support module for performing support operations, in accordance with various embodiments.

FIG. 2 is a block diagram of a CPM system that may include the CPM support module of FIG. 1, in accordance with various embodiments.

FIG. 3 is a flow diagram of an example method of performing CPM support operations, in accordance with various embodiments.

FIG. 4A illustrates an example pixel array processed by the CPM support module of FIG. 1, in accordance with various embodiments.

FIG. 4B illustrates a graph of example histograms used to determine a probability of a second charged particle event within a pixel array, in accordance with various embodiments.

FIG. 4C illustrates a graph of an example probability equation using the example histograms of FIG. 4B, in accordance with various embodiments.

FIG. 4D illustrates an example probability matrix determined by the CPM support module of FIG. 1 for the example pixel array of FIG. 4A, in accordance with various embodiments.

FIG. 5 is an example of a graphical user interface that may be used in the performance of some or all of the CPM support methods disclosed herein, in accordance with various embodiments.

FIG. 6 is a block diagram of an example computing device that may perform some or all of the CPM support methods disclosed herein, in accordance with various embodiments.

FIG. 7 is a block diagram of an example CPM support system in which some or all of the CPM support methods disclosed herein may be performed, in accordance with various embodiments.

Detailed Description

Disclosed herein are charged particle microscope (CPM) support systems, as well as methods, apparatuses, systems, and computer-readable media related to detecting charged particle events for charged particle microscopes. For example, in some embodiments, a charged particle microscope support apparatus includes: first logic to detect a first charged particle event at a first pixel of a charged particle camera; second logic to detect, within a subregion of pixels of the charged particle camera containing the first pixel, whether a second charged particle event is present based on a dose rate and an energy value of each pixel within the subregion of pixels and, when the second charged particle event is determined to be present, determine a location of the second charged particle event within the subregion; and third logic to output charged particle event data representing the first charged particle event and the second charged particle event.

The CPM support embodiments disclosed herein may achieve improved performance relative to conventional approaches. In conventional microscopy systems, the systems operate at a high frame rate and a low probe current (e.g., dose rate) so each raw image frame generated by a camera contains a sparse signal (e.g., each frame contains only one electron event for a defined number of pixels). Conventional microscopy systems apply a threshold that allows a counting algorithm to be applied to each frame to detect the sparse signal. The counting algorithm assigns each electron incident on the detector to an individual pixel of each frame. The sparsity of each raw frame is necessary to avoid coincidence loss (e.g., events where two or more electrons hit the same and/or overlapping parts of a sensor of the system at almost the same time and are incorrectly counted as only one electron). Thus, conventional microscopy systems require summing a large number of counted frames to form an electron counting image, which means that the effective frame rate (e.g., the rate at which usable images are generated) of the detector is much slower in electron counting mode than it is in integrating mode. In other conventional microscopy systems, counting algorithms assign a count of one (1) electron to each event detected within each pixel of a frame above a threshold energy. In these systems, the detector operates at a faster rate than a frame readout speed, allowing each pixel to record multiple events in each frame. However, as the dose rate increases, undercounting (e.g., coincidence loss) occurs and, when electron energies greatly exceed the threshold energy resulting in electron charges spreading over multiple pixels, overcounting occurs. In some conventional microscopy systems, a charged particle camera contains a filter and a local maximum finder. The filter shapes the input grey levels associated with electrons and the local maximum finder identifies an event that is the maximum of a certain region by accepting the most energetic event of the certain region. However, at higher dose rates, events tend to overlap within a region and, thus, inaccurate event counting occurs due to the local maximum finder discarding lower energy events.

The CPM support embodiments disclosed herein may detect a second electron loss to coincidence at high electron dose rates, such as, for example, dose rates at or above 13 electrons per physical pixel per second (eps) including, for example, dose rates from 20 to 30 eps (approximately 1/6 or 1/10 electron per pixel per frame). Various ones of the embodiments disclosed herein may improve upon conventional approaches to achieve technical advantages, such as, for example, an approximately four-fold increase in throughput while maintaining image quality by estimating a probability of a second electron event proximate to a detected electron event. Such technical advantages are not achievable by routine and conventional approaches, and all users of systems including such embodiments may benefit from these advantages. The technical features of the embodiments disclosed herein are thus decidedly unconventional in the field of microscopy, as are the combinations of the features of the embodiments disclosed herein. The present disclosure thus introduces functionality that neither a conventional computing device, nor a human, could perform.

Accordingly, embodiments of the present disclosure may serve any of a number of technical purposes, such as determining from measurements how to control an image analysis; improving the signal-to-noise-ratio in a charged particle microscope; reducing the amount of sensor data (e.g., image frames) to be processed; or providing a faster processing of sensor data. In particular, the present disclosure provides technical solutions to technical problems, including but not limited to improving image quality (e.g., detective quantum efficiency (DQE)) and reduced processing time prior to single particle analysis (SPA) reconstruction.

Embodiments disclosed herein thus provide improvements to CPM support systems technology (e.g., improvements in the computer technology supporting CPMs, among other improvements).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the subject matter disclosed herein. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices.

The description uses the phrases "an embodiment," "various embodiments," and "some embodiments," each of which may refer to one or more of the same or different embodiments. Furthermore, the terms "comprising," "including," "having," and the like, as used with respect to embodiments of the present disclosure, are synonymous. When used to describe a range of dimensions, the phrase "between X and Y" represents a range that includes X and Y. As used herein, an "apparatus" may refer to any individual device, collection of devices, part of a device, or collections of parts of devices. The drawings are not necessarily to scale.

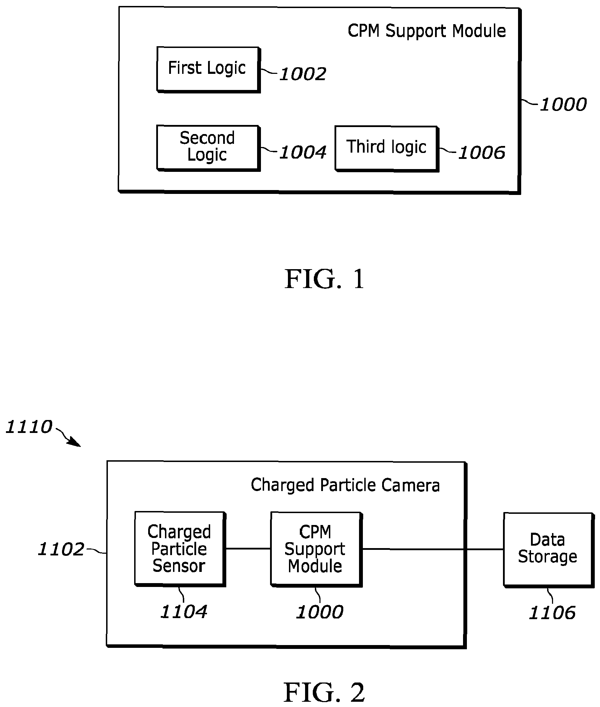

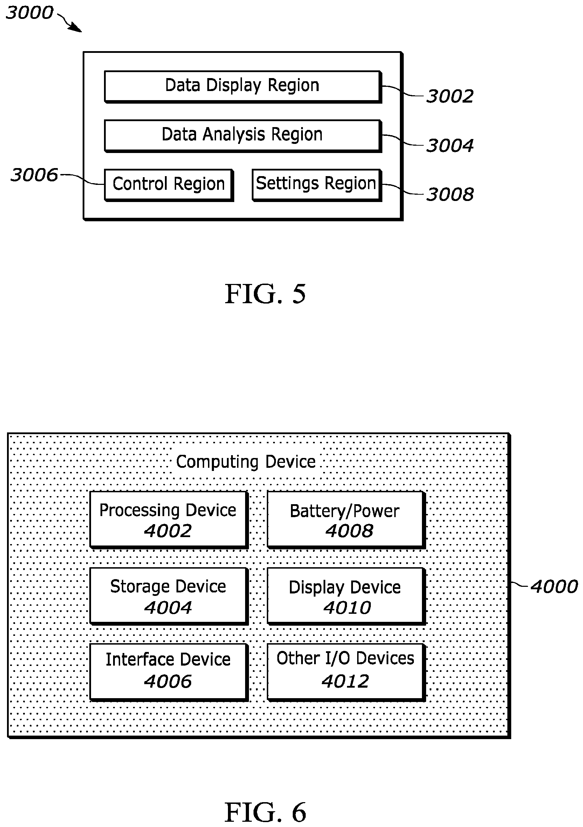

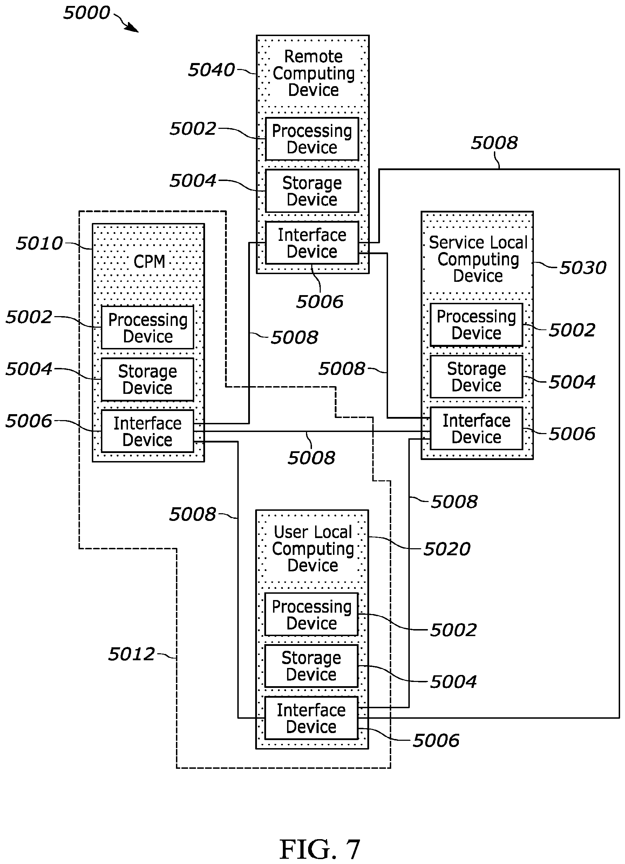

FIG. 1 is a block diagram of a CPM support module 1000 for performing support operations, in accordance with various embodiments. The CPM support module 1000 may be implemented by circuitry (e.g., including electrical and/or optical components), such as a programmed computing device. The logic of the CPM support module 1000 may be included in a single computing device or may be distributed across multiple computing devices that are in communication with each other as appropriate. Examples of computing devices that may, singly or in combination, implement the CPM support module 1000 are discussed herein with reference to the computing device 4000 of FIG. 6, and examples of systems of interconnected computing devices, in which the CPM support module 1000 may be implemented across one or more of the computing devices, is discussed herein with reference to the CPM support system 5000 of FIG. 7. The CPM whose operations are supported by the CPM support module 1000 may include any suitable type of CPM, such as a scanning electron microscope (SEM), a transmission electron microscope (TEM), a scanning transmission electron microscope (STEM), or an ion beam microscope.

The CPM support module 1000 may include first logic 1002, second logic 1004, and third logic 1006. As used herein, the term "logic" may include an apparatus that is to perform a set of operations associated with the logic. For example, any of the logic elements included in the CPM support module 1000 may be implemented by one or more computing devices programmed with instructions to cause one or more processing devices of the computing devices to perform the associated set of operations. In a particular embodiment, a logic element may include one or more non-transitory computer-readable media having instructions thereon that, when executed by one or more processing devices of one or more computing devices, cause the one or more computing devices to perform the associated set of operations. As used herein, the term "module" may refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module may not include all of the logic elements depicted in the associated drawing; for example, a module may include a subset of the logic elements depicted in the associated drawing when that module is to perform a subset of the operations discussed herein with reference to that module. In some particular embodiments, the CPM support module 1000 may be implemented by programmed field programmable gate arrays (FPGAs) that may be part of a charged particle camera.

FIG. 2 is a block diagram of a CPM system or apparatus 1110 that includes the CPM support module 1000 and a charged particle camera 1102 (also referred to herein as a counting camera or an electron counting camera) communicatively coupled to a data storage 1106 (e.g., multiple hard drives). During use, the charged particle camera 1102 may be used as part of a CPM (e.g., the CPM 5010 discussed below with reference to FIG. 7) to image a specimen, and the CPM support module 1000 may generate data (to be stored in the data storage 1106) representative of charged particle events in this imaging. Data stored in the data storage 1106 may be accessible by reconstruction logic that may perform single particle analysis (SPA), tomographic reconstruction, or any other suitable reconstruction technique using the data generated by the charged particle camera 1102 to reconstruct the microscopic structure of the specimen. In the CPM system 1110, the charged particle camera 1102 may include a charged particle sensor 1104 communicatively coupled to the CPM support module 1000 (e.g., any of the logic modules of the CPM support module 1000 disclosed herein). The charged particle sensor 1104 may take any suitable form for detecting appropriate charged particles. For example, in some embodiments, the charged particle sensor 1104 may include complementing metal oxide semiconductor (CMOS) sensor pixels for electron detection. Although FIG. 2 illustrates the CPM support module 1000 as being included in the charged particle camera 1102, the CPM support module 1000 (or one or more logic modules of the CPM support module 1000 disclosed herein) may be located external to the charged particle camera 1102 and may communicate with the charged particle camera 1102 over one or more wired or wireless communication channels and, optionally, through one or more intermediary devices. Similarly, although the data storage 1106 is illustrated as being external to the charged particle camera 1102, the data storage 1016 or a portion thereof may be included within the charged particle camera 1102, the CPM support module 1000, or a combination thereof. Accordingly, the CPM system 1110 illustrated in FIG. 2 is provided as one example configuration and should not be construed as limiting.

The first logic 1002 is configured to detect a first charged particle event corresponding to an electron impinging a subregion of the charged particle sensor 1104. For example, in some embodiments, the first logic 1002 is configured to detect the first charged particle event based on an energy value associated with charge collected from an electron that strikes the subregion of the charged particle sensor 1104. The first logic 1002 may compare the energy value to a threshold energy value to detect the first charged particle event. In other embodiments, the first logic 1002 may detect the first charged particle event by determining a maximum energy value of a pixel in the subregion based on comparisons of the energy values of pixels in the subregion. In further embodiments, the first logic 1002 may be configured to detect the first charged particle event using any suitable electron detection methodology.

The second logic 1004 is configured to detect whether a second charged particle event corresponding to a second electron impinged the subregion of the charged particle sensor 1104 is present and, if so, a location of the second charged particle event. The second charged particle event represents an electron impinging the subregion of the charged particle sensor 1104 of the charged particle camera 1102 within a same frame interval as the first charged particle event detected by the first logic 1002. The second logic 1004 determines whether the second charged particle event is present in the subregion of the charged particle sensor 1104 based on a dose rate (e.g., an average dose rate) used to image the specimen and the energy values of pixels within the subregion where the first charged particle event was detected. As described in more detail below, the subregion may vary in shape (e.g., a square, a rectangle, a blob, or similar shaped area) and size, one or both of which may vary based on the charged particle sensor design (e.g., thickness, internal fields, etc.). In some embodiments, the second logic 1004 is configured to determine whether the second charged particle event is present in the subregion by determining a probability of a second charged particle event based on energy values within the subregion. A probability may be determined for each individual pixel within the subregion, wherein the probability for a particular pixel may be based on the energy value of the pixel, the energy values of one or more other pixels in the subregion (e.g., one or more neighboring pixels), or a combination thereof. Further details regarding determining such probabilities are described below. As also described in more detail below, in some embodiments, when the determined probabilities satisfy a predetermined threshold (i.e., predetermined probability threshold), which may vary based on the dose rate (i.e., the probability indicates a high likelihood of a second charged particle event), the second logic 1004

5

determines a location of the second charged particle event within the subregion. In some embodiments, the second logic 1004 determine the location of the second charged particle event based on a sub-maximum energy value within the subregion (i.e., a maximum of energy values in the subregion excluding the energy value associated with the pixel representing the first charged particle event).

The third logic 1006 is configured to output information about detected charged particle events (e.g., to the data storage 1106 of the CPM system 1110), such as, for example, charged particle event indicators. A charged particle event indicator may identify a time and a location of a detected charged particle event. In some embodiments, the time of a charged particle event indicator may be a frame interval N representative of the associated charged particle event happening during the frame interval associated with the capture of the Nth frame of pixel array data, wherein combining the frame number N with the frame rate may allow a time (e.g., in the unit of seconds) to be identified. In some embodiments, the location of a charged particle event indicator may reflect the pixel at which the associated charged particle event was detected. The pixel location of a charged particle event indicator may be determined based on signals generated by the charged particle sensor 1104. For example, a charged particle event (e.g., an electron event) may cause charge carriers to be generated across an area of the charged particle sensor 1104. The centroid or other property of this area may be calculated in accordance with any suitable known technique to estimate a location for the charged particle event to subpixel accuracy. Charged particle event indicators generated by the first logic 1002 and/or the second logic 1004 may include other charged particle event information in addition to time and location. The charge particle event indicators output by the third logic 1006 may be structured in various file or data formats or structures, such as, for example, Extensible Markup Language (XML), JavaScript Object Notation (JSON), or Comma-Separated Value (CSV).

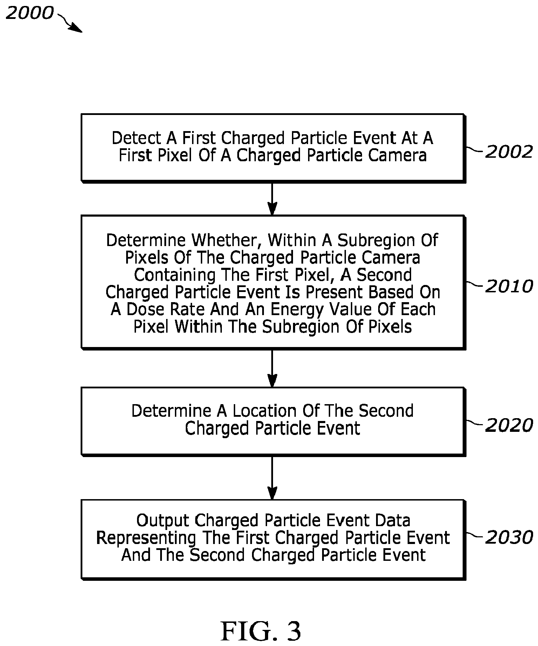

FIG. 3 is a flow diagram of a method 2000 of performing CPM support operations, in accordance with various embodiments. Although the operations of the method 2000 may be illustrated with reference to particular embodiments disclosed herein (e.g., the CPM support modules 1000 discussed herein with reference to FIG. 1, the GUI 3000 discussed herein with reference to FIG. 5, the computing devices 4000 discussed herein with reference to FIG. 6, and/or the CPM support system 5000 discussed herein with reference to FIG. 7), the method 2000 may be used in any suitable setting to perform any suitable support operations. Operations are illustrated once each and in a particular order in FIG. 3, but the operations may be reordered and/or repeated as desired and appropriate (e.g., different operations performed may be performed in parallel, as suitable). Also, although operations may be described as being performed by one of the first, second, or third logics 1002, 1004, and 1006 of the CPM support module 1000, the operations may be distributed in various ways among any number of modules or logic.

As illustrated in FIG. 3, at 2002, the first logic 1002 detects a first charged particle event at a first pixel of a charged particle camera may be detected. For example, the first logic 1002 of the CPM support module 1000 may perform the operations of 2002 in accordance with any suitable method including conventional detection techniques described above. As one example, the first logic 1002 may utilize a local maximum finder to identify a pixel with a maximum energy value of a subregion of the charged particle sensor 1104.

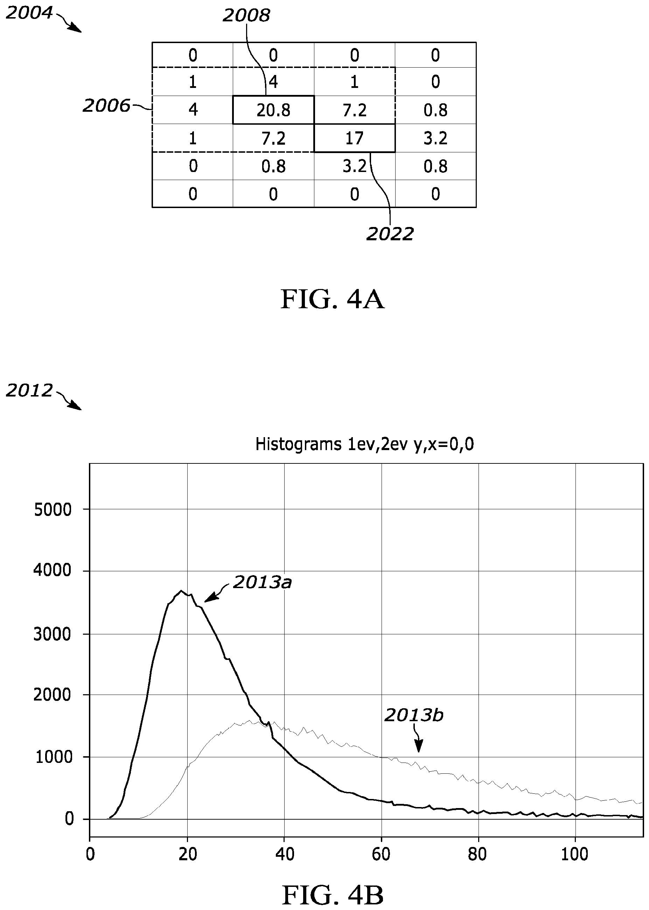

For example, FIG. 4A illustrates an example pixel array (image) 2004 of the charged particle sensor 1104. The pixel array 2004 includes a plurality of individual pixels, wherein each pixel of the pixel array 2004 includes an energy value that corresponds to the amount of charge each pixel collects from one or more electrons. Using this example, the first logic 1002 may detect the first charged particle event by detecting a pixel within a subregion 2006 having the maximum energy value. In the example pixel array 2004, pixel 2008 has a maximum energy value (e.g., 20.8), and, thus, the first logic 1002 may identify pixel 2008 as a location of a charged particle event (the "first" charged particle event). In some embodiments, the first logic 1002 may also compare the maximum energy value within a subregion of pixels to a predetermined threshold (i.e., predetermined energy threshold) when detecting the first charged particle event. In other words, the first logic 1002 may be configured to detect a charged particle event within a subregion when a maximum energy value within the subregion satisfies a predetermined energy threshold. Also, in some embodiments, the first logic 1002 (or a separate logic module) may perform one or more preprocessing steps on the pixel array 2004 prior to detecting the first charged particle event, such as, for example, performing one or more filtering steps, such as, for example, converting the pixel energy values to grey levels.

The subregion 2006 illustrated in FIG. 4A includes nine (9) individual pixels in a 3 x 3 rectangular configuration. However, the subregion 2006 may include additional or fewer pixels depending on the application and may include various configurations depending on the charged particle sensor 1104. For example, as noted above, a subregion of pixels processed via the CPM support module 1000 may have various shapes and sizes and, in some embodiments, the size, shape, or both of a subregion processed via the CPM support module 1000 may depend on an average blob-size, which is typically dependent on high-tension and sensor design (thickness, internal fields, etc.). For example, a 3 x 3 rectangular subregion may be useful for 300keV applications. Also, although various numbers of pixels may be included in a subregion, the number may be kept small, since the signal-to-noise ratio may deteriorate as the number of pixels increases.

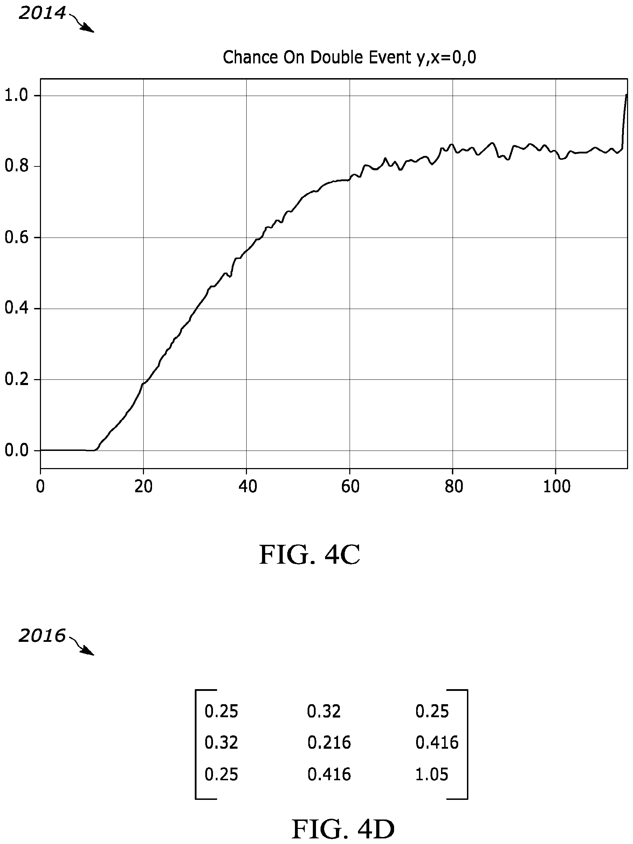

Returning to FIG. 3, at 2010, in response to first logic 1002 detecting the first charged particle event, the second logic 1004 determines whether a second charged particle event is present within a subregion of pixels where the first charged particle event was detected (i.e., within the subregion containing the first pixel representing the location of the first charged particle event). The second logic 1004 may determine whether the second charged particle event is present based on a dose rate and an energy value of each pixel within the subregion of pixels. For example, returning to the example pixel array 2004, in some embodiments, the second logic 1004 calculates a probability of one (1) charge particle event versus two (2) charged particle events in the subregion 2006 as a function of the energy levels of each of the nine (9) individual pixels. The second logic 1004 may use an equation to calculate the probability, such as, for example, Equation (1) set forth below, wherein $p(g)$ is the probability of a two (double) charged particle event for given an energy value ($g$) of a pixel, $h1(g)$ is a first histogram value (number of pixels) for a single charged particle event (1ev) for the energy value ($g$), and $h2$ is a second histogram value (number of pixels) of a double charged particle event (2ev) for the energy value ($g$). FIG. 4B includes a graph 2012 graphically illustrating example first histogram values and second histogram values for pixel energy levels, and FIG. 4C includes a second graph 2014 that graphically illustrates the Equation 1 for pixel energy levels based on the histograms of FIG. 4B.

$$p(g) = \frac{h2(g)}{h1(g)+h2(g)} \qquad\qquad \text{Equation 1}$$

The histograms may be generated using low dose images and, once created, can be applied to high dose images using Equation 1. For example, the histograms may be based on single blobs and, for high dose rates, the form of such blobs does not change but the blobs may land closer together. Creating the histograms may involve two steps. As a first step, charged particle events are detected in the low dose images. This step may include three sub-steps (after correction for dark signals or other pre-processing steps), which may include (a) filtering the raw image, (b) finding all local maxima in pixel subregions (e.g., 3x3 subregions) of the filtered image, and (c) thresholding the identified local maxima (e.g., comparing the local maximum to a predetermined energy threshold) to identify events in the image. A blob (e.g., a 3x3 subregion of pixels) is defined around each detected event with the event located at the center pixel of the subregion. The energy values of the center pixels are then added to the first histogram 213a illustrated in FIG. 4B.

In the second step of the creation of the histograms, each blob is expanded to a larger blob (e.g., a 5x5 subregion). For example, in some embodiments, for each 3x3 subregion of grey scale values defined around a detected event, an edge of 1 pixel is added, wherein each added pixel as a value of 0. This expansion results in a 5x5 blob with a black edge. Random pairs of blobs are then combined, wherein each pair includes one of the expanded 5x5 blobs and one of the original 3x3 blob (e.g., for a different event than the event represented in the 5x5 blob). For example, from the expanded 5x5 blobs, a random 5x5 blob is selected and the randomly-selected 5x5 blob is added to a randomly-selected 3x3 blob. Combining the blobs includes adding energy values at individual pixels. As the 3x3 blob is smaller in size than the expanded 5x5 blob, the randomly-selected 3x3 blob is added to a random region of the randomly-selected 5x5 blob (e.g., there are 9 possible choices). The resulting combination is a 5x5 blob including two events, and the center pixel of the 5x5 combined blob is added to the second histogram 213b illustrated in FIG. 4B. This combination is repeated for each of the 9 possible choices for combining the randomly-selected 3x3 blob and the randomly-selected 5x5 blob, such that 9 combinations are created for a selected pair of blobs and 9 center values are added to the second histogram 213b. The above combinations are repeated for multiple pairs of blobs to build the second histogram 213b.

The second logic 1004 uses the generated probabilities to determine whether a second charged particle event is present within the subregion where the first charged particle event was detected. For example, in some embodiments, using the generated probability matrix, the second logic 1004 determines a probability total by adding the highest (pmax) and lowest (pmin) probability values of the subregion. For example, FIG. 4D illustrates a set of probabilities (a probability matrix) 2016 generated for the example subregion 2006 using Equation 1 and the example histograms represented in FIG. 4B (wherein each probability value in the matrix corresponds to a pixel in the subregion 2006. With respect to the example probability matrix 2016, 1.05 (which may be capped at 1.0 for probability purposes) is the maximum probability and 0.216 is the lowest probability value (i.e., a minimum probability). Accordingly, in this example, the second logic 1004 determines a probability total of 1.216.

In some embodiments, the second logic 1004 determines whether the second charged particle event is present by comparing the probability total to a predetermined probability threshold. The predetermined probability threshold may be based on the dose rate. For example, in some embodiments, the predetermined probability threshold may have a value 1 minus an adjustment value (alpha) that varies with the dose rate, wherein the alpha values increases as the dose rate increases. When the probability total satisfies (e.g., exceeds greater than) the predetermined probability threshold, there is a higher likelihood that two charged particle events are represented in the subregion 2006 than one charged particle event, and the second logic 1004 determines that a second charged particle event is present in the subregion 2006.

Returning to FIG. 3, at 2020, when the second logic 1004 determines that a second charged particle event is present in the subregion of pixels (at 2010), the second logic 1004 determines a location of the second charged particle event within the subregion where the first charged particle event was detected. In some embodiments, the second logic 1004 is configured to identify the location of the second charged particle event based on a pixel of the subregion of the charged particle sensor 1104 associated with the sub-maximum energy value. The sub-maximum energy value is the highest energy value excluding the energy value associated with the pixel related to the first charged particle event detected by the first logic 1002. The second logic 1004 may determine the sub-maximum energy value by comparing energy values within the subregion 2006 or using a local maximum finder as described above with respect to the first logic 1002 configured to ignore an energy value related to a pixel location associated with the first charged particle event. For example, as illustrated in FIG. 4A, pixel 2022, a second pixel of the subregion, has the sub-maximum energy level within the subregion 2006 and, thus, is set by the second logic 1004 as the location of the second charged particle event.

Again, returning to FIG. 3, at 2030, the third logic 1006 outputs charged particle event data representing the first charged particle event and the second charged particle event. For example, third logic 1006 may be configured to output data representative of a set of charged particle event indicators, including event indicators for the first charged particle event and the second charged particle event. These indicators may be generated by the third logic 1006 (using data output by the first logic 1002 and the second logic 1004), may be by the first logic 1002 and the second logic 1004, or a combination thereof. The charged particle event indicators or information contained therein may be used in various applications, such as, for example, single particle analysis (SPA) reconstruction or electron-based spectroscopy, such as, for example, electron energy loss spectroscopy (EELS), energy-dispersive x-ray spectroscopy, or the like. Accordingly, as described above, improving the accuracy of detecting charged particle events results in improved data input to various analysis systems and methods, which results in improved output and improved use and operation of microscopy equipment as well as other equipment and systems using the results of such analysis. Similarly, information regarding detected events may be presented to a user through one or more user, which may allow the user to more efficiently or accurately operate the microscopy equipment or other equipment. Thus, embodiments described herein improve microscopy technology and related equipment and functions.

As noted, the CPM support methods disclosed herein may include interactions with a human user (e.g., via the user local computing device 5020 discussed herein with reference to FIG. 7). These interactions may include providing information to the user (e.g., information regarding the operation of a CPM such as the CPM 5010 of FIG. 7, information regarding a sample being analyzed or other test or measurement performed by a CPM, information retrieved from a local or remote database, or other information) or providing an option for a user to input commands (e.g., to control the operation of a CPM such as the CPM 5010 of FIG. 7, or to control the analysis of data generated by a CPM), queries (e.g., to a local or remote database), or other information. In some embodiments, these interactions may be performed through a graphical user interface (GUI) that includes a visual display on a display device (e.g., the display device 4010 discussed herein with reference to FIG. 6) that provides outputs to the user and/or prompts the user to provide inputs (e.g., via one or more input devices, such as a keyboard, mouse, trackpad, or touchscreen, included in the other I/O devices 4012 discussed herein with reference to FIG. 6). The CPM support systems disclosed herein may include any suitable GUIs for interaction with a user.

FIG. 5 depicts an example GUI 3000 that may be used in the performance of some or all of the support methods disclosed herein, in accordance with various embodiments. As noted above, the GUI 3000 may be provided on a display device (e.g., the display device 4010 discussed herein with reference to FIG. 6) of a computing device (e.g., the computing device 4000 discussed herein with reference to FIG. 6) of a CPM support system (e.g., the CPM support system 5000 discussed herein with reference to FIG. 7), and a user may interact with the GUI 3000 using any suitable input device (e.g., any of the input devices included in the other I/O devices 4012 discussed herein with reference to FIG. 6) and input technique (e.g., movement of a cursor, motion capture, facial recognition, gesture detection, voice recognition, actuation of buttons, etc.).

The GUI 3000 may include a data display region 3002, a data analysis region 3004, a CPM control region 3006, and a settings region 3008. The particular number and arrangement of regions depicted in FIG. 5 is simply illustrative, and any number and arrangement of regions, including any desired features, may be included in a GUI 3000.

The data display region 3002 may display data generated by a CPM (e.g., the CPM 5010 discussed herein with reference to FIG. 7). For example, the data display region 3002 may display charged particle event indicators output by the third logic 1006 of a CPM support module 1000 (or data representative thereof).

The data analysis region 3004 may display the results of data analysis (e.g., the results of analyzing the data illustrated in the data display region 3002 and/or other data). For example, the data analysis region 3004 may display a reconstruction or other representation of a specimen imaged in accordance with any of the techniques disclosed herein. In some embodiments, the data display region 3002 and the data analysis region 3004 may be combined in the GUI 3000 (e.g., to include data output from a CPM, and some analysis of the data, in a common graph or region).

The CPM control region 3006 may include options that allow the user to control a scientific instrument (e.g., the CPM 5010 discussed herein with reference to FIG. 7). For example, the CPM control region 3006 may include control options to program, start, or stop imaging operations.

The settings region 3008 may include options that allow the user to control the features and functions of the GUI 3000 (and/or other GUIs) and/or perform common computing operations with respect to the data display region 3002 and data analysis region 3004 (e.g., saving data on a storage device, such as the storage device 4004 discussed herein with reference to FIG. 6, sending data to another user, labeling data, etc.). For example, the settings region 3008 may include information about charged particle events of the charged particle camera 1102 (e.g., as determined by the first logic 1002 or the second logic 1004).

As noted above, the CPM support module 1000 may be implemented by one or more computing devices. FIG. 6 is a block diagram of a computing device 4000 that may perform some or all of the scientific instrument support methods disclosed herein, in accordance with various embodiments. In some embodiments, the CPM support module 1000 may be implemented by a single computing device 4000 or by multiple computing devices 4000. Further, as discussed below, a computing device 4000 (or multiple computing devices 4000) that implements the CPM support module 1000 may be part of one or more of the CPM 5010, the user local computing device 5020, the service local computing device 5030, or the remote computing device 5040 of FIG. 7.

The computing device 4000 of FIG. 6 is illustrated as having a number of components, but any one or more of these components may be omitted or duplicated, as suitable for the application and setting. In some embodiments, some or all of the components included in the computing device 4000 may be attached to one or more motherboards and enclosed in a housing (e.g., including plastic, metal, and/or other materials). In some embodiments, some these components may be fabricated onto a single system-on-a-chip (SoC) (e.g., an SoC may include one or more processing devices 4002 and one or more storage devices 4004). Additionally, in various embodiments, the computing device 4000 may not include one or more of the components illustrated in FIG. 6, but may include interface circuitry (not shown) for coupling to the one or more components using any suitable interface (e.g., a Universal Serial Bus (USB) interface, a High-Definition Multimedia interface (HDMI) interface, a Controller Area Network (CAN) interface, a Serial Peripheral interface (SPI) interface, an Ethernet interface, a wireless interface, or any other appropriate interface). For example, the computing device 4000 may not include a display device 4010, but may include display device interface circuitry (e.g., a connector and driver circuitry) to which a display device 4010 may be coupled.

The computing device 4000 may include a processing device 4002 (e.g., one or more processing devices). As used herein, the term "processing device" may refer to any device or portion of a device that processes electronic data from registers and/or memory to transform that electronic data into other electronic data that may be stored in registers and/or memory. The processing device 4002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 4000 may include a storage device 4004 (e.g., one or more storage devices). The storage device 4004 may include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some embodiments, the storage device 4004 may include memory that shares a die with a processing device 4002. In such an embodiment, the memory may be used as cache memory and may include embedded dynamic random access memory (eDRAM) or spin transfer torque magnetic random access memory (STT-MRAM), for example. In some embodiments, the storage device 4004 may include non-transitory computer readable media having instructions thereon that, when executed by one or more processing devices (e.g., the processing device 4002), cause the computing device 4000 to perform any appropriate ones of or portions of the methods disclosed herein.

The computing device 4000 may include an interface device 4006 (e.g., one or more interface devices 4006). The interface device 4006 may include one or more communication chips, connectors, and/or other hardware and software to govern communications between the computing device 4000 and other computing devices. For example, the interface device 4006 may include circuitry for managing wireless communications for the transfer of data to and from the computing device 4000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. Circuitry included in the interface device 4006 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). In some embodiments, circuitry included in the interface device 4006 for managing wireless communications may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some embodiments, circuitry included in the interface device 4006 for managing wireless communications may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some embodiments, circuitry included in the interface device 4006 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some embodiments, the interface device 4006 may include one or more antennas (e.g., one or more antenna arrays) to receipt and/or transmission of wireless communications.

In some embodiments, the interface device 4006 may include circuitry for managing wired communications, such as electrical, optical, or any other suitable communication protocols. For example, the interface device 4006 may include circuitry to support communications in accordance with Ethernet technologies. In some embodiments, the interface device 4006 may support both wireless and wired communication, and/or may support multiple wired communication protocols and/or multiple wireless communication protocols. For example, a first set of circuitry of the interface device 4006 may be dedicated to shorter-range wireless communications such as Wi-Fi or Bluetooth, and a second set of circuitry of the interface device 4006 may be dedicated to longer-range wireless communications such as global positioning system (GPS), EDGE, GPRS, CDMA, WiMAX, LTE, EV-DO, or others. In some embodiments, a first set of circuitry of the interface device 4006 may be dedicated to wireless communications, and a second set of circuitry of the interface device 4006 may be dedicated to wired communications.

The computing device 4000 may include battery/power circuitry 4008. The battery/power circuitry 4008 may include one or more energy storage devices (e.g., batteries or capacitors) and/or circuitry for coupling components of the computing device 4000 to an energy source separate from the computing device 4000 (e.g., AC line power).

The computing device 4000 may include a display device 4010 (e.g., multiple display devices). The display device 4010 may include any visual indicators, such as a heads-up display, a computer monitor, a projector, a touchscreen display, a liquid crystal display (LCD), a light-emitting diode display, or a flat panel display.

The computing device 4000 may include other input/output (I/O) devices 4012. The other I/O devices 4012 may include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 4000, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 4000 may have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultra mobile personal computer, etc.), a desktop computing device, or a server computing device or other networked computing component.

One or more computing devices implementing any of the CPM support modules or methods disclosed herein may be part of a CPM support system. FIG. 7 is a block diagram of an example CPM support system 5000 in which some or all of the CPM support methods disclosed herein may be performed, in accordance with various embodiments. The CPM support modules and methods disclosed herein (e.g., the CPM support module 1000 of FIG. 1 and the method 2000 of FIG. 4) may be implemented by one or more of the CPM 5010, the user local computing device 5020, the service local computing device 5030, or the remote computing device 5040 of the CPM support system 5000.

Any of the CPM 5010, the user local computing device 5020, the service local computing device 5030, or the remote computing device 5040 may include any of the embodiments of the computing device 4000 discussed herein with reference to FIG. 6, and any of the CPM 5010, the user local computing device 5020, the service local computing device 5030, or the remote computing device 5040 may take the form of any appropriate ones of the embodiments of the computing device 4000 discussed herein with reference to FIG. 6.

The CPM 5010, the user local computing device 5020, the service local computing device 5030, or the remote computing device 5040 may each include a processing device 5002, a storage device 5004, and an interface device 5006. The processing device 5002 may take any suitable form, including the form of any of the processing devices 4002 discussed herein with reference to FIG. 4, and the processing devices 5002 included in different ones of the CPM 5010, the user local computing device 5020, the service local computing device 5030, or the remote computing device 5040 may take the same form or different forms. The storage device 5004 may take any suitable form, including the form of any of the storage devices 5004 discussed herein with reference to FIG. 4, and the storage devices 5004 included in different ones of the CPM 5010, the user local computing device 5020, the service local computing device 5030, or the remote computing device 5040 may take the same form or different forms. The interface device 5006 may take any suitable form, including the form of any of the interface devices 4006 discussed herein with reference to FIG. 4, and the interface devices 5006 included in different ones of the CPM 5010, the user local computing device 5020, the service local computing device 5030, or the remote computing device 5040 may take the same form or different forms.

The CPM 5010, the user local computing device 5020, the service local computing device 5030, and the remote computing device 5040 may be in communication with other elements of the CPM support system 5000 via communication pathways 5008. The communication pathways 5008 may communicatively couple the interface devices 5006 of different ones of the elements of the CPM support system 5000, as shown, and may be wired or wireless communication pathways (e.g., in accordance with any of the communication techniques discussed herein with reference to the interface devices 4006 of the computing device 4000 of FIG. 6). The CPM support system 5000 depicted in FIG. 7 includes communication pathways between each pair of the CPM 5010, the user local computing device 5020, the service local computing device 5030, and the remote computing device 5040, but this "fully connected" implementation is simply illustrative, and in various embodiments, various ones of the communication pathways 5008 may be absent. For example, in some embodiments, a service local computing device 5030 may not have a direct communication pathway 5008 between its interface device 5006 and the interface device 5006 of the CPM 5010 but may instead communicate with the CPM 5010 via the communication pathway 5008 between the service local computing device 5030 and the user local computing device 5020 and the communication pathway 5008 between the user local computing device 5020 and the CPM 5010.

Returning to FIG. 7, the user local computing device 5020 may be a computing device (e.g., in accordance with any of the embodiments of the computing device 4000 discussed herein) that is local to a user of the CPM 5010. In some embodiments, the user local computing device 5020 may also be local to the CPM 5010, but this need not be the case; for example, a user local computing device 5020 that is in a user's home or office may be remote from, but in communication with, the CPM 5010 so that the user may use the user local computing device 5020 to control and/or access data from the CPM 5010. In some embodiments, the user local computing device 5020 may be a laptop, smartphone, or tablet device. In some embodiments the user local computing device 5020 may be a portable computing device.

The service local computing device 5030 may be a computing device (e.g., in accordance with any of the embodiments of the computing device 4000 discussed herein) that is local to an entity that services the CPM 5010. For example, the service local computing device 5030 may be local to a manufacturer of the CPM 5010 or to a third-party service company. In some embodiments, the service local computing device 5030 may communicate with the CPM 5010, the user local computing device 5020, and/or the remote computing device 5040 (e.g., via a direct communication pathway 5008 or via multiple "indirect" communication pathways 5008, as discussed above) to receive data regarding the operation of the CPM 5010, the user local computing device 5020, and/or the remote computing device 5040. In some embodiments, the service local computing device 5030 may communicate with the CPM 5010, the user local computing device 5020, and/or the remote computing device 5040 (e.g., via a direct communication pathway 5008 or via multiple "indirect" communication pathways 5008, as discussed above) to transmit data to the CPM 5010, the user local computing device 5020, and/or the remote computing device 5040 (e.g., to update programmed instructions, such as firmware, in the CPM 5010, to initiate the performance of the CPM 5010, the CPM support module 1000 or both, to configure the CPM support module 1000 (e.g., to set thresholds, set a probability equation, or the like), to update programmed instructions, such as software, in the user local computing device 5020 or the remote computing device 5040, etc.). A user of the CPM 5010 may utilize the CPM 5010 or the user local computing device 5020 to communicate with the service local computing device 5030 to report a problem with the CPM 5010 or the user local computing device 5020, to request a visit from a technician to improve the operation of the CPM 5010, to order consumables or replacement parts associated with the CPM 5010, or for other purposes.

The remote computing device 5040 may be a computing device (e.g., in accordance with any of the embodiments of the computing device 4000 discussed herein) that is remote from the scientific instrument 5010 and/or from the user local computing device 5020. In some embodiments, the remote computing device 5040 may be included in a datacenter or other large-scale server environment. In some embodiments, the remote computing device 5040 may include network-attached storage (e.g., as part of the storage device 5004). The remote computing device 5040 may store data generated by the CPM 5010, perform analyses of the data generated by the CPM 5010 (e.g., in accordance with programmed instructions), facilitate communication between the user local computing device 5020 and the CPM 5010, and/or facilitate communication between the service local computing device 5030 and the CPM 5010.

In some embodiments, one or more of the elements of the CPM support system 5000 illustrated in FIG. 7 may not be present. Further, in some embodiments, multiple ones of various ones of the elements of the CPM support system 5000 of FIG. 7 may be present. For example, a CPM support system 5000 may include multiple user local computing devices 5020 (e.g., different user local computing devices 5020 associated with different users or in different locations). In another example, a scientific instrument support system 5000 may include multiple CPMs 5010, all in communication with service local computing device 5030 and/or a remote computing device 5040; in such an embodiment, the service local computing device 5030 may monitor these multiple CPMs 5010, and the service local computing device 5030 may cause updates or other information may be "broadcast" to multiple CPMs 5010 at the same time. Different ones of the CPMs 5010 in a CPM support system 5000 may be located close to one another (e.g., in the same room) or farther from one another (e.g., on different floors of a building, in different buildings, in different cities, etc.). In some embodiments, a CPM 5010 may be connected to an Internet-of-Things (IoT) stack that allows for command and control of the CPM 5010 through a web-based application, a virtual or augmented reality application, a mobile application, and/or a desktop application. Any of these applications may be accessed by a user operating the user local computing device 5020 in communication with the CPM 5010 by the intervening remote computing device 5040. In some embodiments, a CPM 5010 may be sold by the manufacturer along with one or more associated user local computing devices 5020 as part of a local CPM computing unit 5012.

The following paragraphs provide various examples of the embodiments disclosed herein.

Example 1 is a computing device, including XXX.

Example 2 may include the subject matter of Example 1, and may further specify that XXX.

Example A includes any of the scientific instrument support modules disclosed herein.

Example B includes any of the methods disclosed herein.

Example C includes any of the GUIs disclosed herein.

Example D includes any of the scientific instrument support computing devices and systems disclosed herein.

## Claims

1. A charged particle microscope support apparatus, comprising:

   first logic to detect a first charged particle event at a first pixel of a charged particle camera;
   second logic to determine, within a subregion of pixels of the charged particle camera containing the first pixel, whether a second charged particle event is present based on a dose rate and an energy value of each pixel within the subregion of pixels and, when the second charged particle event is determined to be present, determine a location of the second charged particle event within the subregion of pixels; and
   third logic to output charged particle event data representing the first charged particle event and the second charged particle event.

2. The charged particle microscope support apparatus of claim 1, wherein the second logic determines the location of the second charged particle event based on a second pixel within the subregion of pixels having a sub-maximum energy value, the sub-maximum energy value being a maximum of energy values within the subregion of pixels excluding the energy value of the first pixel.

3. The charged particle microscope support apparatus of claim 1, wherein the second logic determines whether the second charged particle event is present by:

   determining, for each pixel within the subregion of pixels, a probability of a charged particle impinging the pixel, and
   determining that the second charged particle event is present based on the probability determined for each pixel within the subregion of pixels.

4. The charged particle microscope support apparatus of claim 1, wherein the second logic determines whether the second charged particle event is present by:

   determining, for each pixel within the subregion of pixels, a probability of a charged particle impinging the pixel, determining a probability total by adding a minimum probability within the subregion of pixels and a maximum probability within the subregion of pixels, and
   determining that the second charged particle event is present in response to the probability total being greater than a predetermined threshold.

5. The charged particle microscope support apparatus of claim 4, wherein the predetermined threshold is set based on the dose rate.

6. The charged particle microscope support apparatus of claim 1, wherein the subregion of pixels includes a square area of 3 to 5 pixels.

7. A charged particle microscope, comprising the charged particle microscope support apparatus of any preceding claim.

8. A method of supporting a charged particle microscope, comprising:

detecting, with a processing device, a first charged particle event at a first pixel of a charged particle camera;

determining, with the processing device within a subregion of pixels of the charged particle camera containing the first pixel, whether a second charged particle event is present based a dose rate and an energy value of each pixel within the subregion of pixels;

when the second charged particle event is determined, determining, with the processing device, a location of the second charged particle event within the subregion of pixels; and

outputting, with the processing device, charged particle event data representing the first charged particle event and the second charged particle event.

9. The method of claim 8, wherein the location of the second charged particle event is determined based on a second pixel within the subregion of pixels having a sub-maximum energy value, the sub-maximum energy value being a maximum of energy values within the subregion of pixels excluding the energy value of the first pixel.

10. The method of claim 8, wherein determining whether the second charged particle event is present includes:

determining, for each pixel within the subregion of pixels, a probability of a charged particle impinging the pixel, and

determining that the second charged particle event is present based on the probability determined for each pixel within the subregion of pixels.

11. The method of claim 8, wherein determining whether the second charged particle event is present includes:

determining, for each pixel within the subregion of pixels, a probability of a charged particle impinging the pixel, determining a probability total by adding a minimum probability within the subregion of pixels and a maximum probability within the subregion of pixels, and

determining that the second charged particle event is present in response to the probability total being greater than a predetermined threshold.

12. The method of claim 11, wherein the predetermined threshold is set based on the dose rate.

13. The method of claim 9, wherein the subregion of pixels includes a square area of 3 to 5 pixels.

14. The method of claim 9, wherein determining whether the second charged particle event is present includes: determining a probability for each pixel within the subregion of pixels based on a first histogram of energy values for single charged particle events and a second histogram of energy values for double charged particle events.

15. The method of claim 9, further comprising:

generating the first histogram by detecting charged particle events in a low dose image, defining a first blob for each detected charged particle event, and adding the energy value of a center of each blob to the first histogram; and

generating the second histogram by expanding each first blob into a second blob, combining random pairs of blobs to generate combined blobs, wherein each random pair of blobs includes one of the first blobs and one of the second blobs, and adding an energy value of a center of each combined blob to the second histogram.

CPM Support Module

First Logic ~1002

Second Logic ~1004

Third logic ~1006

~1000

FIG. 1

1110

Charged Particle Camera

1102~

Charged Particle Sensor

1104

CPM Support Module

1000

Data Storage

1106

FIG. 2

*2000*

Detect A First Charged Particle Event At A First Pixel Of A Charged Particle Camera — *2002*

Determine Whether, Within A Subregion Of Pixels Of The Charged Particle Camera Containing The First Pixel, A Second Charged Particle Event Is Present Based On A Dose Rate And An Energy Value Of Each Pixel Within The Subregion Of Pixels — *2010*

Determine A Location Of The Second Charged Particle Event — *2020*

Output Charged Particle Event Data Representing The First Charged Particle Event And The Second Charged Particle Event — *2030*

FIG. 3

FIG. 4A

FIG. 4B

2014

Chance On Double Event y,x=0,0

FIG. 4C

2016

$$\begin{bmatrix} 0.25 & 0.32 & 0.25 \\ 0.32 & 0.216 & 0.416 \\ 0.25 & 0.416 & 1.05 \end{bmatrix}$$

FIG. 4D

3000

```
┌─────────────────────────────────────────┐
│  ┌─────────────────────────────────┐     │
│  │      Data Display Region        │───── 3002
│  └─────────────────────────────────┘     │
│  ┌─────────────────────────────────┐     │
│  │      Data Analysis Region       │───── 3004
│  └─────────────────────────────────┘     │
3006 ─┌──────────────┐ ┌──────────────┐     │
│  │Control Region│ │Settings Region│──── 3008
│  └──────────────┘ └──────────────┘     │
└─────────────────────────────────────────┘
```

# FIG. 5

```
┌───────────────────────────────────────────────┐
│ ::::::::::::::: Computing Device :::::::::::::: │
│  ┌──────────────────┐  ┌──────────────────┐    │
│  │ Processing Device│  │  Battery/Power   │    │
│  │      4002        │  │      4008        │    │
│  └──────────────────┘  └──────────────────┘    │
│  ┌──────────────────┐  ┌──────────────────┐    │
│  │  Storage Device  │  │  Display Device  │──── 4000
│  │      4004        │  │      4010        │    │
│  └──────────────────┘  └──────────────────┘    │
│  ┌──────────────────┐  ┌──────────────────┐    │
│  │ Interface Device │  │ Other I/O Devices│    │
│  │      4006        │  │      4012        │    │
│  └──────────────────┘  └──────────────────┘    │
└───────────────────────────────────────────────┘
```

# FIG. 6

5000

5040 — Remote Computing Device

5002 — Processing Device

5004 — Storage Device

5006 — Interface Device

5008

5008

5008

5010 — CPM

5002 — Processing Device

5004 — Storage Device

5006 — Interface Device

Service Local Computing Device — 5030

Processing Device — 5002

Storage Device — 5004

Interface Device — 5006

5008

5008

5012

User Local Computing Device — 5020

Processing Device — 5002

Storage Device — 5004

Interface Device — 5006

FIG. 7

Europäisches
Patentamt

European
Patent Office

Office européen
des brevets

# EUROPEAN SEARCH REPORT

**Application Number**

EP 23 21 7251

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 11 508 547 B2 (ASML NETHERLANDS BV [NL]) 22 November 2022 (2022-11-22)<br>* column 29, lines 9-36; figures 2A-C,11A,B,14A,B,16A,19A *<br>* column 31, line 49 – column 32, line 65 *<br>* column 36, lines 24-37 *<br>* column 37, lines 21-67 *<br>* column 40, line 16 – column 41, line 9 *<br>* column 48, lines 56-67 *<br>* column 49, line 66 – column 50, line 48 *<br>* column 67, lines 1-20 *<br>* column 71, lines 37-52 *<br>* claim 1 * | 1,3,6-8, 10,13<br>2,4,5,9, 11,12, 14,15 | INV.<br>G01T1/17<br>G01T1/29<br>H01J37/28 |
| A | US 2019/057836 A1 (BUIJSSE BART [NL] ET AL) 21 February 2019 (2019-02-21)<br>* paragraph [0028] * | 14,15 | |
| A | WO 2021/224622 A1 (OXFORD INSTRUMENTS NANOTECHNOLOGY TOOLS LTD [GB]) 11 November 2021 (2021-11-11)<br>* page 8, lines 5-25 *<br>* page 22, line 16 – page 23, line 18 *<br>* page 25, lines 6-16 *<br>* page 26, lines 18-33 *<br>* page 27, lines 7-27 *<br>* page 28, lines 6-9,17-29 * | 1,8 | **TECHNICAL FIELDS SEARCHED (IPC)**<br><br>G01T<br>H01J<br>G01N |

The present search report has been drawn up for all claims

| Place of search | Date of completion of the search | Examiner |
|---|---|---|
| The Hague | 13 May 2024 | Van Ouytsel, Krist'l |

EPO FORM 1503 03.82 (P04C01)

## ANNEX TO THE EUROPEAN SEARCH REPORT
### ON EUROPEAN PATENT APPLICATION NO.

EP 23 21 7251

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2024

| Patent document cited in search report | | Publication date | Patent family member(s) | | Publication date |
|---|---|---|---|---|---|
| US 11508547 | B2 | 22-11-2022 | CN | 112243531 A | 19-01-2021 |
| | | | EP | 3803933 A1 | 14-04-2021 |
| | | | IL | 279203 A | 31-01-2021 |
| | | | JP | 7209744 B2 | 20-01-2023 |
| | | | JP | 2021526714 A | 07-10-2021 |
| | | | JP | 2023052270 A | 11-04-2023 |
| | | | KR | 20210008044 A | 20-01-2021 |
| | | | KR | 20230122180 A | 22-08-2023 |
| | | | SG | 11202011505R A | 30-12-2020 |
| | | | TW | 202001972 A | 01-01-2020 |
| | | | TW | 202324482 A | 16-06-2023 |
| | | | US | 2019378682 A1 | 12-12-2019 |
| | | | US | 2023123152 A1 | 20-04-2023 |
| | | | WO | 2019233991 A1 | 12-12-2019 |
| US 2019057836 | A1 | 21-02-2019 | CN | 109411320 A | 01-03-2019 |
| | | | EP | 3444836 A1 | 20-02-2019 |
| | | | JP | 7105647 B2 | 25-07-2022 |
| | | | JP | 2019035744 A | 07-03-2019 |
| | | | US | 2019057836 A1 | 21-02-2019 |
| | | | US | 2020144022 A1 | 07-05-2020 |
| WO 2021224622 | A1 | 11-11-2021 | CN | 115885171 A | 31-03-2023 |
| | | | EP | 4147034 A1 | 15-03-2023 |
| | | | JP | 2023524128 A | 08-06-2023 |
| | | | US | 2023175991 A1 | 08-06-2023 |
| | | | WO | 2021224622 A1 | 11-11-2021 |

EPO FORM P0459

For more details about this annex : see Official Journal of the European Patent Office, No. 12/82

**EP 4 390 462 A1**

**REFERENCES CITED IN THE DESCRIPTION**

**Patent documents cited in the description**

- US 63476535